# EUROPEAN PATENT SPECIFICATION

(11) **EP 3 499 632 B1**
(45) Date of publication and mention of the grant of the patent: **04.06.2025**
(21) Application number: 18212171.5
(22) Date of filing: 13.12.2018
(51) Int. Cl.: H01M 10/42, H01M 10/48, H01B 7/08, H05K 1/02, H05K 1/11

(54) **CONTACTING UNIT FOR ELECTRICALLY CONTACTING AT LEAST ONE ELECTRONICS SEGMENT OF AN ELECTRONICS MODULE AND METHOD**
KONTAKTIERUNGSEINHEIT ZUR ELEKTRISCHEN KONTAKTIERUNG VON MINDESTENS EINEM ELEKTRONIKSEGMENT EINES ELEKTRONIKMODULS UND VERFAHREN
UNITÉ DE MISE EN CONTACT POUR MISE EN CONTACT ÉLECTRIQUE D'AU MOINS UN SEGMENT D'ÉLECTRONIQUE D'UN MODULE ÉLECTRONIQUE ET PROCÉDÉ

(30) Priority: 15.12.2017 DE 102017222883
(43) Date of publication of application: 19.06.2019
(73) Proprietor: TE Connectivity Germany GmbH, 64625 Bensheim (DE)
(72) Inventor: MICHAEL, Mathias, 68789 St. Leon-Rot (DE); BECKER, Tobias, 68789 St. Leon-Rot (DE)
(74) Representative: Grünecker Patent- und Rechtsanwälte PartG mbB

(56) References cited:
- EP-A2- 1 153 801
- EP-A2- 2 128 912
- DE-A1- 19 819 088
- US-A- 4 065 199
- US-A1- 2017 271 642

## Description

The present invention relates to a contacting unit for electrically contacting at least one battery segment of a battery module. The invention further relates to a contacting system having at least two such contacting units. Furthermore, the invention relates to a battery module having at least one battery segment, the battery segment being contacted by at least one such contacting unit. The present invention further relates to a method for contacting at least one battery segment of a battery module.

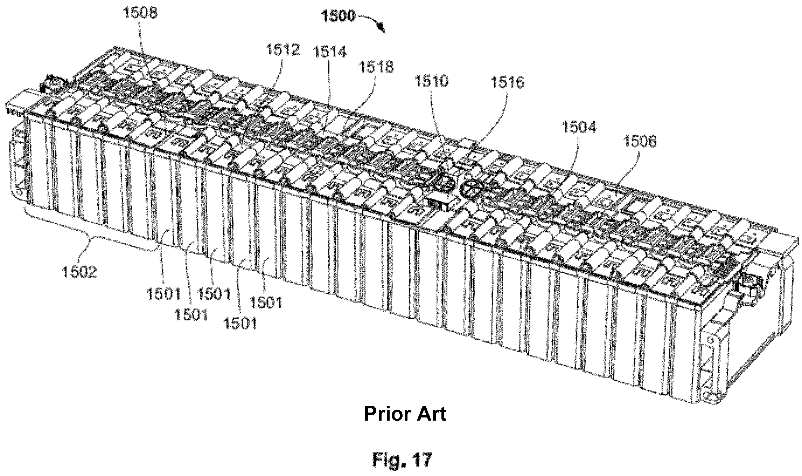

Electrical components, such as battery cells for example, are often combined to form units. Figure 17 shows a perspective depiction of a battery module 1500, as used for example for plug-in hybrid electric vehicles or purely electric vehicles. The battery module 1500 consists of five battery segments 1502 connected in series. Each of the battery segments 1502 consists of five battery cells 1501 connected in parallel.

Each battery cell 1501 has a first electrical terminal 1504, for example the positive pole, and a second electrical terminal 1506, for example the negative pole, which consist of aluminium for example. As shown in Figure 17, the terminals of in each case five adjacent battery cells 1501, connected in parallel, of a battery segment 1502 are electrically connected by using connection plates. It is clear to the person skilled in the art that the same poles, i.e. in each case the positive and the negative poles, are connected to the battery cells 1501 of a battery segment 1502, in order to connect the battery cells 1501 of a battery segment 1502 in parallel.

Furthermore, the adjacent battery segments 1502 are connected in series. In particular, the positive pole of a first battery segment is connected to the negative pole of the adjacent second battery segment. Simultaneously, the electrical connection between the negative pole of a first battery segment is electrically insulated from the positive pole of a second battery segment by means of a segment insulator 1508.

Furthermore, there is the necessity that each battery segment 1502 of the battery module 1500 can be contacted. In particular for electric vehicles, it is necessary for each battery segment 1502 of the battery module 1502 to be monitored by means of a monitoring electronics assembly. As shown in Figure 17, the battery module 1500 comprises a central terminal 1510 for connection to such a monitoring electronics assembly (the monitoring electronics assembly is not shown in Figure 17). The terminal 1510 contacts each battery segment 1502 via a first flat flexible cable 1512 and second flat flexible cable 1514. The flat flexible cables 1512 and 1514 are connected by means of a terminal connector 1516. By means of such a monitoring electronics assembly with the appropriate cabling, it is possible to individually monitor the temperature, the charging status and/or the integrity status, for example, of each battery segment 1502 for the battery module 1500.

DE19819088 (A1) relates to a flexible circuit board consisting of a flexible carrier foil with a number of conducting paths carried by this.

One object of the present invention is to optimise the cabling for electrically contacting the electronics units of the battery module. In particular, it is an object of the present invention to produce the cabling cost-effectively and to avoid excess material. Furthermore, one object consists in using such cabling to enhance the monitoring of the segments.

At least one of these objects is achieved by the subject-matter of the independent claims. Advantageous developments are a constituent part of the dependent claims.

In accordance the present invention, a contacting unit is provided for electrically contacting at least one battery segment of a battery module. The contacting unit comprises a module connector having a first terminal and a second terminal for connection to the battery module, wherein the first terminal is connected to the second terminal via a connection conductor in the direction of a main axis of the contacting unit. Furthermore, the contacting unit comprises at least one segment connector having a first contact element for contacting a first electrical terminal of the battery segment, wherein the first contact element is connected to the connection conductor via a first contact conductor, which comprises a first bending region. Furthermore, the contacting unit comprises a flexible substrate having a contact side, wherein the contact side comprises the module connector and the segment connector, and wherein an angle between a first fold of the flexible substrate, folded in the first bending region, and the main axis is oblique.

Such a contacting unit makes material-saving manufacture possible, since the contactable surface area is increased by folding of the flexible substrate. In particular, such a contacting unit can be manufactured as a narrow strip having a small width b. The flexible substrate is selected for the base material of the strip. The elements for contacting the battery segment and the elements for connection to the battery module are applied to the flexible substrate. In the process, the narrow strip extends in the direction of the connection conductor. Furthermore, the flexible substrate is folded in such a way that the surface contacted by the contacting unit is enlarged. In particular, the width b' of the contacting unit is greater than the width b of the narrow strip. In other words, the fold, which is produced by the folding of the flexible substrate, forms an oblique angle with the main axis. In accordance with a particularly preferred embodiment, the oblique angle is 45°. It is clear to the person skilled in the art that every oblique angle, i.e. every acute or obtuse angle, or put another way, every angle that is not a multiple of 90°, leads to an enlargement of the contactable surface area.

Further it is clear to the person skilled in the art that the module connector can comprise a multiplicity of connection conductors, each having a first and second terminal. Furthermore, the module connector can be connected to the battery module directly or indirectly, for example via an intermediate element. Advantageously, the module connector is designed for data communication.

Furthermore, such a contacting unit makes cost-effective manufacture possible, since only the contact side of the flexible substrate has electrical contacts, whereas the opposing surface of the flexible substrate can be formed as an insulator. By way of the folding of the flexible substrate, both opposing surfaces of the contacting unit can then have electrical contacts. It is clear to the person skilled in the art that the contacting unit can only have contacts on opposing surfaces if the number of folds is odd.

By way of the folding, the flexible substrate for the contacting unit can thus be manufactured, for example, in a layer process. In particular, the flexible substrate can have an insulation layer, on which a contacting layer is applied. Furthermore, an insulating mask can be applied to the contacting layer, which insulating mask has recesses in particular, in the region of the contacts. Such a manufacturing method, by the building-up of layers, is particularly cost-effective and precise.

According to the present invention, the contacting unit further comprises at least one monitoring unit, wherein the first contact conductor of the at least one segment connector is connected to the connection conductor via the monitoring unit. This makes it possible for the segment connector and the module connector to take on various tasks, for example data communication or measurement of data. In particular, the monitoring unit can also be formed as a control unit.

It is particularly advantageous if the at least one monitoring unit comprises a communication unit. According to the present invention, the monitoring unit comprises an evaluation unit. Thus, the segment connector can be used for recording data, for example.

In addition, or alternatively, the module connector can be adapted to communicate with a management unit of the battery module. Thus, the module connector can be formed as a daisy chain, for example.

In accordance with a further advantageous embodiment, the segment connector is adapted to electrically contact a pole of the battery segment. In this case, the pole can be both negative and positive.

According to the present invention, the segment connector comprises a second contact element for contacting a second electrical terminal of the battery segment, wherein the second contact element is connected to the connection conductor via a second contact conductor, which comprises a second bending region. In particular, it is advantageous if the second contact element is adapted to electrically contact a second pole of the battery segment. According to a first embodiment, the first fold comprises the second bending region. According to a second and third embodiment, the first fold does not comprise the second bending region. By means of a second contact element, additional properties, such as the voltage, of the battery segment for example, can be measured, or properties such as the temperature of the battery segment, for example, can be measured more accurately. Moreover, a current can be conducted through the battery segment by way of the second contact element, in order to measure the properties of the battery segment.

According to the present invention, each of the first and second contact elements comprises a pair of contact terminals. Thus, it is possible to increase the accuracy when examining the battery segment, for example by means of an impedance spectroscopy.

According to a further advantageous embodiment, a second fold of the flexible substrate, folded in the second bending region, extends along the direction of the main axis. In particular, it is advantageous if the first contact conductor comprises a third bending region and a third angle between a third fold of the flexible substrate, folded in the third bending region, and the main axis is 90°. In particular, it is advantageous if the second and third bending regions are arranged between the first bending region and the connection of the contact conductor to the connection conductor. Thus, it is possible to fabricate the contacting unit in a particularly material-saving manner.

In accordance with a further advantageous embodiment, the contact side comprises an arm connector. The arm connector comprises a linkage arm terminal for connection to the battery module. The linkage arm terminal is connected to one of the terminals of the module connector via a linkage arm conductor, which comprises a fourth bending region, wherein a fourth angle between a fourth fold of the flexible substrate folded in the fourth bending region and the main axis is oblique. Thus, it is possible, for example, for the monitoring unit to be arranged at identical poles of battery segments connected in series. In particular, thermal coupling at the negative pole of a battery cell is ideal. Thus, it is particularly advantageous to position the monitoring unit, having an additional temperature sensor, at the negative pole of a battery segment.

According to a further aspect, the problem is solved by a contacting system having at least two contacting units according to any one of the abovementioned embodiments, wherein in each case the first and the second terminal of adjacent contacting units are connected to each other.

According to an advantageous embodiment, at least one contacting unit according to any one of the previously mentioned embodiments contacts at least one battery segment of a battery module.

In an advantageous manner, the contact element of the contacting unit is welded to the battery segment. As a result, a particularly stable connection is achieved between the contacting unit and the battery segment.

According to a further advantageous embodiment, each battery segment comprises at least one battery cell. Thus, a connection both in parallel and in series can be obtained in the battery module.

According to a further aspect, the problem is solved by a method for contacting at least one battery segment of a battery module. The method comprises the provision of a module connector having a first terminal and a second terminal for connection to the battery module, wherein the first terminal is connected to the second terminal via a connection conductor in the direction of a main axis of the contacting unit. Furthermore, the method comprises the provision of at least one segment connector having a first contact element for contacting a first electrical terminal of the battery segment, wherein the first contact element is connected to the connection conductor via a first contact conductor, which comprises a first bending region, and the provision of a flexible substrate having a contact side, wherein the contact side comprises the module connector and the at least one segment connector. The method further comprises the folding of the flexible substrate in the first bending region, wherein the angle between a first fold and the main axis is oblique.

To better understand the present invention, it is explained in greater detail using the exemplary embodiments depicted in the following figures. In this case, identical components are indicated with the same reference numerals and the same component names. In the drawings:
- **Fig. 1**: shows a schematic view of a flexible substrate for a contacting unit for contacting a battery segment of a battery module;
- **Fig. 2**: shows a schematic view of the contacting unit;
- **Fig.** 3: shows a further view of the contacting unit;
- **Fig. 4**: shows a section through the contacting unit from Figure 1 along the sectional line IV-IV;
- **Fig. 5**: shows a perspective view of a battery module with a multiplicity of battery segments;
- **Fig. 6**: shows a detail of Figure 5;
- **Fig. 7**: shows a schematic view of the flexible substrate for a contacting unit according to a second embodiment;
- **Fig. 8**: shows a detail of Figure 7;
- **Fig. 9**: shows a contacting unit with a second fold;
- **Fig. 10**: shows the contacting unit from Figure 9 with a third fold;
- **Fig. 11**: shows the contacting unit from Figure 10 with a first fold;
- **Fig. 12**: shows a schematic view of a battery module, wherein the battery segments are contacted by means of a contacting unit of the second embodiment;
- **Fig. 13**: shows a schematic view of the flexible substrate for a contacting unit according to a third embodiment;
- **Fig. 14**: shows a schematic view of the flexible substrate for a contacting system;
- **Fig. 15**: shows a schematic view of the contacting system;
- **Fig. 16**: shows a schematic view of a battery module, wherein the battery segments are contacted by means of a contacting system;
- **Fig. 17**: shows a perspective view of a battery module;

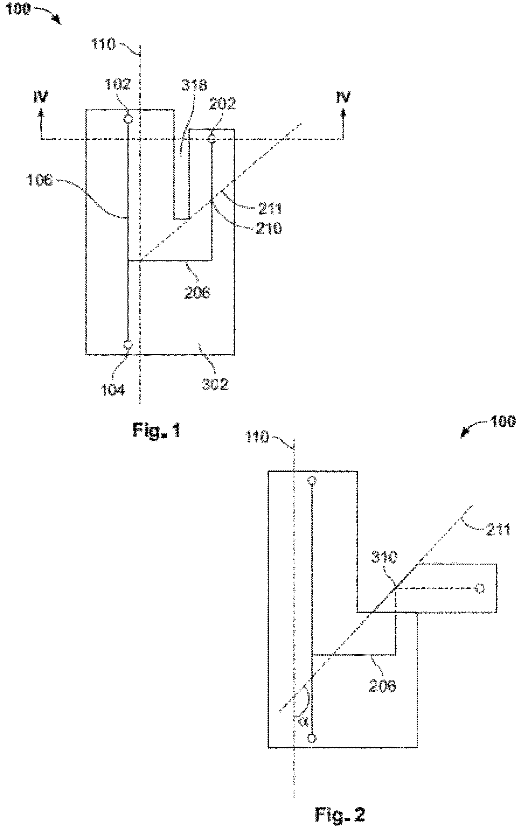

The present invention will now be described using the figures and first of all with Figures 1 to 4. Figures 1 to 4 show a contacting unit 100 for electrically contacting a battery segment of a battery module in accordance with a first embodiment. For example, such a contacting unit 100 can be used to contact battery segments 1502 of the battery module 1500, as shown in Figure 17.

Figure 1 shows the contact side 302 of a flexible substrate having a module connector and a segment connector. In particular, Figure 1 shows the flat, i.e. the unfolded, flexible substrate. The module connector comprises a first terminal 102 and a second terminal 104, which are connected to a connection conductor 106. In this case, the connection conductor 106 extends in the direction of the main axis 110 of the module connector. The direction of the main axis 110 is depicted by a chain-dotted line 110 in Figure 1.

The segment connector comprises a first contact element 202, which is connected to the connection conductor 106 via a first contact conductor 206. The first contact conductor 206 comprises a first bending region 210 in the region of the first bending axis 211, which is depicted by means of a chain-dotted line 211 in Figure 1.

In particular, the first contact conductor 206 of the segment connector extends, in the unfolded flexible substrate, as shown in Figure 1, along the main axis 110 at least in the region between the first bending region 210 and the first contact element 202. Furthermore, in this region the flexible substrate has a gap 318 between the contact conductor 206 and the connection conductor 106.

Figure 2 shows a first surface of the contacting unit 100, which has a fold pattern in accordance with a first embodiment. Regions of the contact conductor 206 which are hidden by the folding in this first view are indicated by a dotted line.

The segment connector has a first fold 310. The first fold 310 extends along the first bending axis 211, which is depicted by a chain-dotted line 211 in Figure 2. The first bending axis 211 forms an oblique angle α with the main axis, which is depicted by the chain-dotted line 110 in Figure 2. In the present case, the oblique angle is 135°.

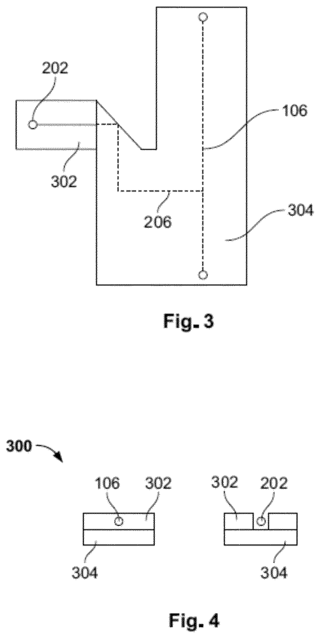

Figure 3 shows a second surface of the contacting unit 100. The second surface lies opposite the first surface of the contacting unit 100 from Figure 2. Regions of the contact conductor 206 and of the connection conductor 106 which are hidden by the folding in this second view are indicated by dotted lines. In particular, the second surface comprises the contact side 302 having the first contact element 202 for contacting the first electrical terminal of a battery segment. In the region of the connection conductor 106 and in parts of the contact conductor 206, the second surface comprises the insulating layer 304. In other words, the contacting unit 100 can be connected to a battery module in such a way that the connection conductor 106 is arranged in a manner electrically insulated from the battery module by means of the insulating layer 304. Simultaneously, the first contact element 202 can electrically contact a battery segment of the battery module.

Figure 4 shows a section along the sectional line IV-IV in Figure 1. The flexible substrate 300 comprises an insulating layer 304. Furthermore, the flexible substrate comprises the contact side 302, which comprises the module connector and the segment connector. The module connector comprises the connection conductor 106 and the segment connector comprises the first contact element 202. By way of example, the contact side 302 can be created by a mask, which has a recess at least in the region of the first contact element 202.

The flexible substrate 300 can be, for example, a flexible printed circuit board (FPCB).

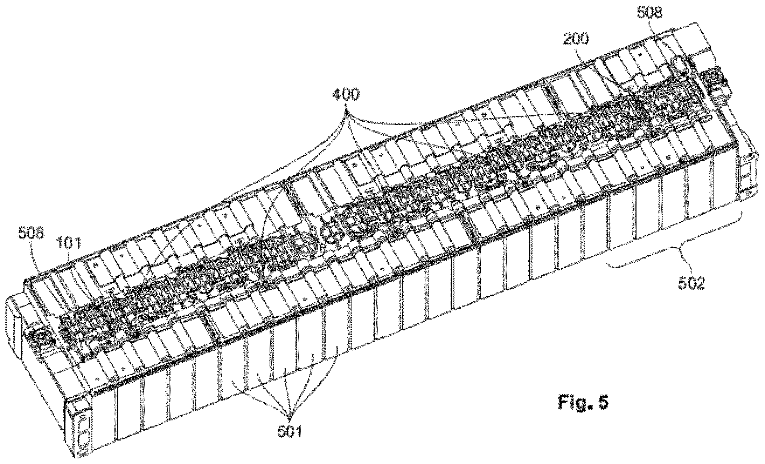

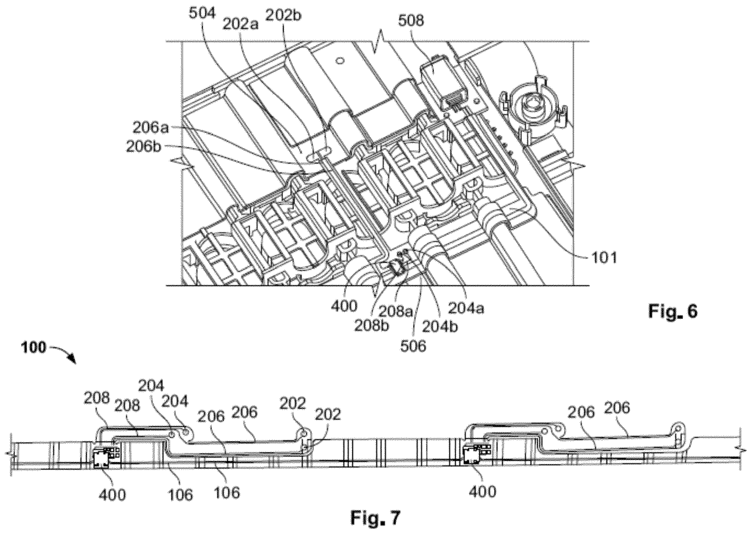

Even if this is not shown in Figures 1 to 4, the contacting unit 100 of the first embodiment can have further segment connectors. Additionally or alternatively, the module connector can comprise a multiplicity of connection conductors, as is described in the following text with reference to Figures 5 and 6 and with reference to the second and third embodiment. Additionally or alternatively, the segment connector can comprise several contact elements, such as the segment connector 200, for example, in Figure 6. In particular, each contact element can comprise a pair of contact terminals in each case.

Figure 5 shows, like Figure 17, a battery module 500 with battery segments 502, wherein each battery segment 502 consists of several battery cells 501. Here, the structure of the battery module 500 is for the most part the same as the battery module 1500, which is described with reference to Figure 17. In particular, the last three digits of the reference numerals correspond to identical structural elements.

In contrast to Figure 17, in Figure 5 a monitoring unit 400 is provided for each of the five battery segments 502. Each of the monitoring units 400 comprises an evaluation unit and a communication unit. Each monitoring unit 400 contacts a battery segment 502 via a segment connector 200. The evaluation unit of the monitoring unit 400 evaluates measurement values which are measured via the segment connector 200. Thus, a set of parameters, for example the temperature, the charging status or the integrity status of the respective battery segment 502, can be determined for each battery segment 502.

Furthermore, each monitoring unit 400 with a module connector 101 is connected to a management unit of the battery module (not shown in the figures) via at least one terminal 508 of the battery module 500. By means of the communication unit of the monitoring unit 400, the monitoring unit 400 communicates with the management unit via the module connector 101. In this way, for example, the parameters evaluated by the evaluation unit can be transferred.

Through the decentralised control of the battery segments 502 via in each case one monitoring unit 400 per battery segment 502, fewer cables are required for the module connector 101. It is clear to the person skilled in the art that, for the transfer of data, the module connector 101 must meet other requirements than the segment connector 200, which is used for determining measurement values. By way of example, the monitoring units 400 can be connected in a daisy chain via the module connector 101.

The segment connector 200 is shown in detail in Figure 6. The segment connector 200 comprises a first contact element 202 and a second contact element 204. The first contact element 202 comprises a pair of contact terminals 202a and 202b, each of the contact terminals 202a and 202b being connected to the monitoring unit 400 via a separate contact conductor 206a and 206b. The second contact element 204 comprises a pair of contact terminals 204a and 204b, each of the contact terminals 204a and 204b being connected to the monitoring unit 400 via a separate contact conductor 208a and 208b.

The first contact element 202 is connected to a first electrical terminal 504 of the battery segment 502. The second contact element 204 is connected to a second electrical terminal 506 of the battery element. The first electrical terminal 504 is, for example, the positive pole of the battery segment 502 and the second electrical terminal 506 is, for example, the negative pole of the battery segment 502.

As shown in Figure 6, each pole of the battery segment is contacted by a pair of electrical terminals. As a result of the contacting of four points of the battery segment 502, the parameters can be measured particularly accurately. By way of example, an impedance spectroscopy can be carried out for examining the battery segment. Furthermore, it is advantageous if the control system 400 measures the temperature of the battery segment 502 independently of the value of the impedance spectroscopy. In particular, a temperature measurement at the negative pole of the battery segment 502 is advantageous, since the temperature coupling is particularly good at the negative pole.

By means of an evaluation unit, each monitoring unit 400 can evaluate parameters of the respective battery segment 502, and can communicate these to the management unit of the battery module 500 via the module connector 101.

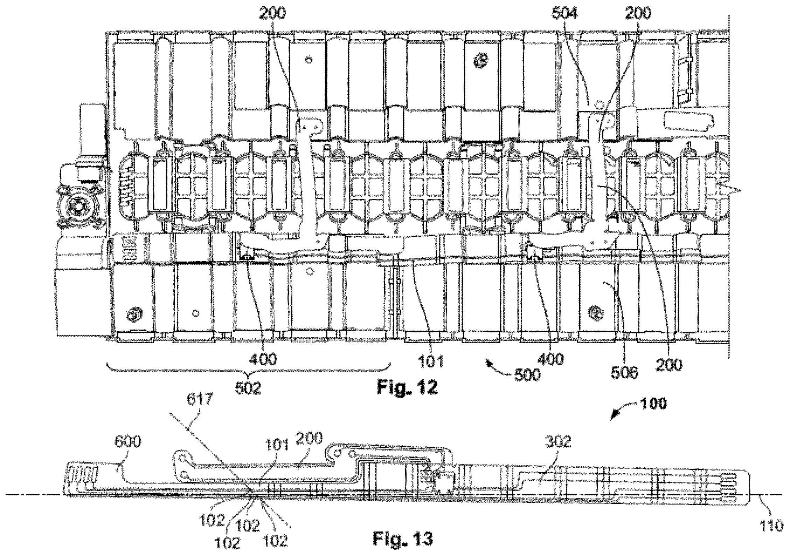

Figures 7 to 11 show a contacting unit 100 for electrically contacting a battery segment of a battery module in accordance with a second embodiment. Figure 12 shows a contacting unit 100 of the second embodiment for electrically contacting a battery segment 502 of a battery module 500. The battery module 500 shown in Figure 12 is the same as the battery module 500 in Figure 5.

The contacting unit 100 of the second embodiment is substantially the same as the contacting unit of the first embodiment. Identical components are provided with identical reference signs. The contacting unit shows, by way of example, a contacting unit 100 of the first embodiment, which is particularly suitable for contacting battery segments 502 of the battery module 500 from Figure 5.

In contrast to the contacting unit 100 of the first embodiment, the flexible substrate of the second embodiment is folded multiple times.

Figure 7 shows the contacting unit 100 having a module connector and two segment connectors. The contacting unit 100 comprises the same elements for contacting the battery segment and the same elements for connection to the battery module, like the contacting described with reference to Figures 5 and 6. In particular, the contacting unit comprises a module connector having two connection conductors 106. Moreover, the contacting unit 100 comprises two segment connectors. Each segment connector comprises a first contact element 202 and a second contact element 204, wherein each of the contact elements comprises a pair of contact terminals. Each segment connector is connected to a monitoring unit 400. Each monitoring unit 400 is connected to the connection conductor 106 of the module connector. For further details about the module connector, the segment connector and the monitoring unit, reference is made to the description of Figures 5 and 6.

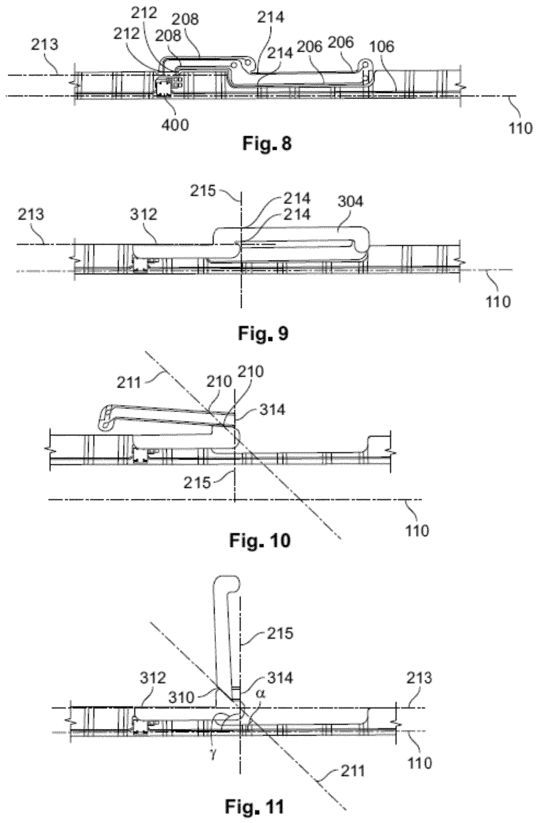

Figure 8 shows a region of the contacting unit 100 with a segment connector. Figures 9 to 11 show the individual steps of the folding of the contacting unit 100.

Figure 8 shows the contact side 302 of a flexible substrate having a module connector and a segment connector. In particular, Figure 8 shows the flat, i.e. the unfolded, flexible substrate. The connection conductor 106 extends in the direction of the main axis 110, which is depicted by the chain-dotted line 110 in Figure 8. The segment connector comprises a pair of first contact conductors 206 and a pair of second contact conductors 208, which are connected to the connection conductor 106 via the monitoring unit 400. Each of the first and second contact conductors 206 and 208 comprises, in the region of the second bending axis 213, which is depicted by the chain-dotted line 213 in Figure 8, a second bending region 212.

Figure 9 shows the contacting unit 100 of the second embodiment, wherein the flexible substrate is folded once. By means of the first folding, according to the second embodiment the segment connector comprises the second fold 312, which extends along the second bending axis 213. In particular, the second fold 312 extends along the direction of the main axis 110. Furthermore, the contacting unit 100 comprises a third bending axis 215, which is depicted by the chain-dotted line 215 in Figure 9. In the region of the third bending axis, each of the first and second contact conductors 206 and 208 comprises a third bending region 214. In Figure 9, the third bending region is hidden by the insulating layer 304 of the flexible substrate.

Figure 10 shows the contacting unit 100 of the second embodiment, wherein the flexible substrate is folded twice. By means of the second folding of the second embodiment, the segment connector comprises the second fold 314, which extends along the second bending axis 215. In particular, the third fold 314 extends perpendicular to the direction of the main axis 110. Furthermore, the contacting unit 100 comprises a first bending axis 211, which is depicted by the chain-dotted line 211 in Figure 10. In the region of the first bending axis 211, each of the first and second contact conductors 206 and 208 comprises a first bending region 210.

Figure 11 shows the contacting unit 100 according to the second embodiment, wherein the flexible substrate is folded three times. By means of the third folding of the second embodiment, the segment connector comprises the first fold 310, which extends along the first bending axis 211. In particular, the first bending axis 211 forms an oblique angle α of 45° with the main axis 110. The second bending axis 213, which comprises the second fold 312, extends in the direction of the first main axis 110. The third bending axis 215, which comprises the third fold 314, forms a right angle γ of 90° with the main axis.

Figure 12 shows the contacting unit 100 of the second embodiment, wherein the contacting unit 100 contacts battery segments 502 of a battery module 500. Each segment connector 200 contacts a first electrical terminal 504 and a second electrical terminal 506 of a battery segment 502. Each segment connector 200 is connected to the module connector 101 via a monitoring unit 400.

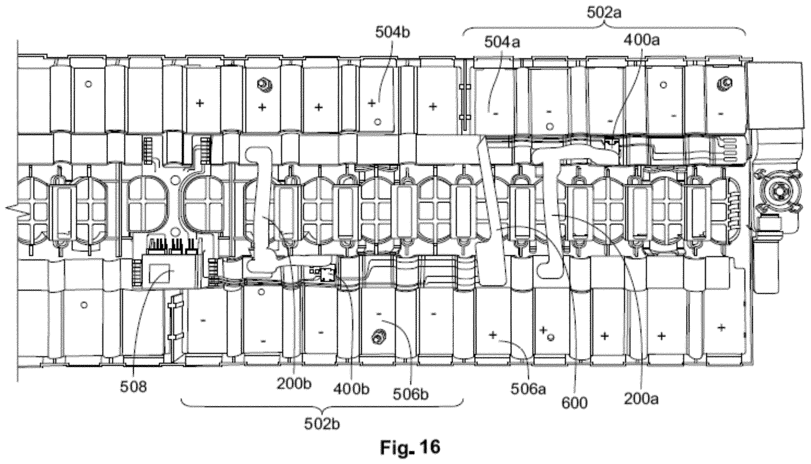

Figures 13 to 16 show a contacting unit 100 for electrically contacting a battery segment of a battery module in accordance with a third embodiment. Figure 16 shows a contacting unit 100 of the third embodiment for electrically contacting a battery segment 502 of a battery module 500. The battery module 500 shown in Figure 16 corresponds to the battery module 500 from Figures 5 and 12.

The contacting unit 100 of the third embodiment is substantially the same as the contacting unit of the first and second embodiments. Identical components are provided with identical reference symbols.

In contrast to the contacting unit 100 of the first and second embodiments, as shown, for example, in Figure 12, the contacting unit 100 of the third embodiment makes it possible, as shown for example in Figure 16, for the module connector 101 to be positioned at the negative pole, i.e. therefore either at the first electrical terminal 504 or at the second electrical terminal 506 of the battery segment 502. Thus the monitoring unit 400, for example, which contains an additional temperature sensor, of each contacting unit 100 can be positioned at the negative pole of the battery segment 502. This is advantageous, in particular, as the thermal coupling at the negative pole of the battery segment 502 is particularly good.

Figure 13 shows the contact side 302 of a contacting unit 100 of the third embodiment. In particular, Figure 13 shows the flat, i.e. therefore the unfolded, flexible substrate. The contacting unit 100 comprises a module connector 101, a segment connector 200 and additionally an arm connector 600. The module connector 101 and the segment connector 200 are substantially the same as the module connector and the segment connector of the second embodiment. In particular, each of the first terminals 102 of the module connector 101 is connected in each case to a linkage arm conductor 606 of the arm connector 600 in the region of the fourth bending axis 617, the chain-dotted line 617.

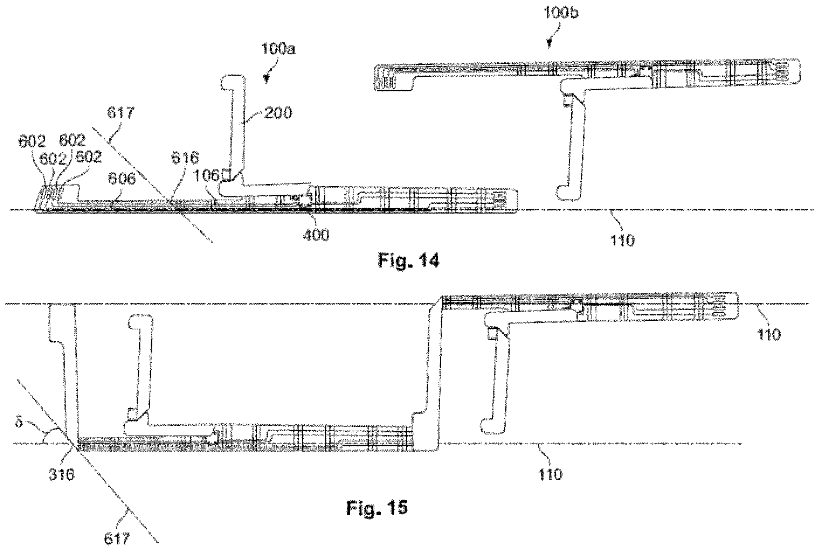

Figure 14 shows two contacting units 100 of the third embodiment, wherein the segment connector 200 is folded in accordance with the second embodiment, as described with reference to Figures 8 to 11. In particular, Figure 14 shows the flat, i.e. the unfolded, flexible substrate of the arm connector and of the module connector. The arm connector comprises four linkage arm terminals 602, which are connected to the monitoring unit 400 by in each case a linkage arm conductor 606 via in each case a connection conductor 106. Each connection conductor 606 of the arm connector extends in the direction of the main axis 110 of the module connector, which is depicted by the chain-dotted line 110 in Figure 14. Each connection conductor 106 is connected to a linkage arm conductor 606 in the region of the fourth bending axis 617, which is depicted by the chain-dotted line 617 in Figure 14, in a fourth bending region 616. It is clear to the person skilled in the art that the present connection is not limited to four connection terminals 602.

Figure 15 shows two contacting units 100 of the third embodiment, wherein the flexible substrate is folded four times. The flexible substrate is folded three times, as shown in Figure 11. Additionally, the flexible substrate is folded a fourth time. By means of the fourth folding of the third embodiment, the arm connector comprises the fourth fold 316, which extends along the fourth bending axis 617. In particular, the fourth bending axis 617 forms an oblique angle δ of 45° with the main axis 110.

Furthermore, Figures 14 and 15 show a contacting system that comprises a first contacting unit 100a and a second contacting unit 100b. In particular, the contacting units 100a and 100b are contacting units 100 of the third embodiment. It is clear to the person skilled in the art that the contacting system can also comprise contacting units 100 of the first and second designs.

Figure 16 shows the contacting system that has two contacting units 100a and 100b of the third embodiment, and contacts the battery segments 502 of a battery module 500. As a result of the series connection of the battery segments 502, the polarity of adjacent battery segments reverses. For example the first terminal 504 of the first battery segment 502a is a first negative pole 504a and the second terminal of the first battery segment 502a is a first positive pole 506a. Accordingly, the first terminal 504 of the second battery segment 502b is a positive pole 504b and the second terminal 506 of the second battery segment 502b is a negative pole 506b.

Each module connector 101a and 101b contacts in each case the negative pole 504a and 506a of a battery segment 502a and 502b. In particular, the monitoring unit 400a and 400b contacts the negative pole 504a and 506a. Furthermore, each segment connector 200a and 200b contacts a first electrical terminal 504 and a second electrical terminal 506 of each battery segment 502. Each segment connector 200a and 200b is connected to the module connector 101a and 101b via a monitoring unit 400a and 400b. The module connector 101a of the first contacting unit 100a is connected to the module connector 101b of the second contacting unit 100b via a first arm connector 600. The module connector 101b of the second contacting unit 100b is connected to a terminal for a management unit 508.

The contacting unit of the present invention can be manufactured in a simple and material-saving manner. The present invention is advantageous in the electrical contacting of battery segments of battery modules. By folding a flexible substrate, the contactable surface area can be enlarged. In this way, the contacting unit can be manufactured as a narrow strip having a predetermined length I and a small width b. By means of the folding, the contactable surface area is not limited by the small width b.

The device for contacting battery segments of a battery module can be used, for example, for battery segments of a battery module, in particular in electrically driven vehicles, for monitoring the individual battery segments, with the outlay for the cabling being reduced simultaneously. Therefore the present invention also relates to a contacting unit for contacting a battery segment of a battery module.

**List of reference symbols:**

| **Reference numeral** | **Description** |
|---|---|
| 100, 100a, 100b | contacting unit |
| 101, 101a, 101b | module connector |
| 102 | first terminal of the module connector |
| 104 | second terminal of the module connector |
| 106 | connection conductor |
| 110 | direction of the main axis |
| 200 | segment connector |
| 202 | first contact element |
| 202a, 202b | first pair of contact terminals |
| 204 | second contact element |
| 204a, 204b | second pair of contact terminals |
| 206, 206a, 206b | first contact conductor |
| 208, 208a, 208b | second contact conductor |
| 210 | first bending region |
| 211 | first bending axis |
| 212 | second bending region |
| 213 | second bending axis |
| 214 | third bending region |
| 215 | third bending axis |
| 300 | flexible substrate |
| 302 | contact side |
| 304 | insulating layer |
| 310 | first fold |
| 312 | second fold |
| 314 | third fold |
| 316 | fourth fold |
| 318 | Gap |
| 400 | monitoring unit |
| 500, 1500 | battery module |
| 501, 1501 | battery cell |
| 502, 1502 | battery segment |
| 504, 1504 | first electrical terminal |
| 506, 1506 | second electrical terminal |
| 508, 1508 | terminal for a management unit |
| 510 | terminal for a monitoring electronics assembly |
| 1512 | first flat flexible cable |
| 1514 | second flat flexible cable |
| 516, 1516 | terminal connector |
| 600 | arm connector |
| 602 | linkage arm terminal |
| 606 | linkage arm conductor |
| 616 | fourth bending region |
| 617 | fourth bending axis |

## Claims

1. A contacting unit (100) for electrically contacting at least one battery segment (502) of a battery module (500), comprising:
a module connector having a first terminal (102) and a second terminal (104) for connection to the battery module, wherein the first terminal is connected to the second terminal via a connection conductor (106) in the direction of a main axis (110) of the contacting unit,
at least one segment connector having a first contact element (202) for contacting a first electrical terminal of the battery segment, wherein the first contact element is connected to the connection conductor via a first contact conductor (206), wherein the first contact conductor (206) comprises a first bending region (210),
a flexible substrate (300) having a contact side (302), wherein the contact side comprises the module connector and the segment connector,
wherein an angle (α) between a first fold (310) of the flexible substrate, folded in the first bending region, and the main axis is oblique,
wherein the at least one segment connector comprises a second contact element for contacting a second electrical terminal of the battery segment, wherein the second contact element (204) is connected to the connection conductor via a second contact conductor (208), the second contact conductor (208) comprises a second bending region (212),
wherein each of the first and second contact elements comprises a pair of contact terminals; and
a monitoring unit (400), wherein the first and the second contact conductor of the at least one segment connector is connected to the connection conductor via the monitoring unit and the unit comprises an evaluation unit.

2. The contacting unit according to Claim1, **characterised in that** the at least one monitoring unit comprises a communication unit.

3. The contacting unit according to any one of Claims 1 to 2, **characterised in that** the module connector is adapted to communicate with a management unit of the battery module.

4. The contacting unit according to any one of Claims 1 to 3, **characterised in that** the segment connector is adapted to electrically contact a pole (506) of the battery segment.

5. The contacting unit according to any one of Claims 1 to 4, **characterised in that** a second fold (312) of the flexible substrate, folded in the second bending region, extends along the direction of the main axis.

6. The contacting unit according to Claim 5, **characterised in that** the first contact conductor comprises a third bending region (314) and a third angle (γ) between a third fold (314) of the flexible substrate, folded in the third bending region, and the main axis is 90°.

7. The contacting unit according to any one of Claims 1 to 6 **characterised in that** the contact side comprises an arm connector,
wherein the arm connector comprises a linkage arm terminal (602) for connection to the battery module,
wherein the linkage arm terminal is connected to one of the terminals of the module connector via a linkage arm conductor (606), the linkage arm conductor comprises a fourth bending region (616), and
wherein a fourth angle (δ) between a fourth fold (316) of the flexible substrate, folded in the fourth bending region, and the main axis is oblique.

8. A contacting system, comprising at least two contacting units (100, 100a, 100b) according to any one of Claims 1 to 7, wherein in each case the first and the second terminal of adjacent contacting units are connected to each other.

9. A battery module (500) having at least one battery segment (502), **characterised in that** the battery segment is contacted by at least one contacting unit (100) according to any one of Claims 1 to 8.

10. The battery module according to Claim 9, **characterised in that** the first and the second contact elements are welded to the battery segment.

11. The battery module according to either one of Claims 9 or 10, **characterised in that** the battery segment comprises at least one battery cell.

12. A method for contacting at least one battery segment of a battery module,
providing a module connector having a first terminal and a second terminal for connection to the battery module, wherein the first terminal is connected to the second terminal via a connection conductor in the direction of a main axis of the contacting unit,
providing at least one segment connector having a first contact element for contacting a first electrical terminal of the battery segment, wherein the first contact element is connected to the connection conductor via a first contact conductor, wherein the first contact conductor comprises a first bending region, wherein the segment connector comprises a second contact element for contacting a second electrical terminal of the battery segment, wherein the second contact element (204) is connected to the connection conductor via a second contact conductor (208), which comprises a second bending region (212) and
wherein each of the first and second contact elements comprises a pair of contact terminals
providing a monitoring unit (400), wherein the first and the second contact conductor of the at least one segment connector is connected to the connection conductor via the monitoring unit and the at least one monitoring unit comprises an evaluation unit providing a flexible substrate having a contact side, wherein the contact side comprises the module connector and the at least one segment connector,
folding of the flexible substrate in the first bending region, wherein the angle between a first fold and the main axis is oblique, and
contacting the battery segment of the electronic module with the first contact element and the second contact element.

## Patentansprüche

1. Kontaktierungseinheit (100) zur elektrischen Kontaktierung mindestens eines Batteriesegments (502) eines Batteriemoduls (500), aufweisend:
einen Modulverbinder mit einem ersten Anschluss (102) und einem zweiten Anschluss (104) zur Verbindung mit dem Batteriemodul, wobei der erste Anschluss mit dem zweiten Anschluss über einen Verbindungsleiter (106) in Richtung einer Hauptachse (110) der Kontaktierungseinheit verbunden ist,
mindestens einen Segmentverbinder mit einem ersten Kontaktelement (202) zur Kontaktierung eines ersten elektrischen Anschlusses des Batteriesegments, wobei das erste Kontaktelement über einen ersten Kontaktleiter (206) mit dem Verbindungsleiter verbunden ist, wobei der erste Kontaktleiter (206) einen ersten Biegebereich (210) aufweisend ist,
ein flexibles Substrat (300) mit einer Kontaktseite (302), wobei die Kontaktseite den Modulanschluss und den Segmentverbinder umfasst,
wobei ein Winkel (α) zwischen einer ersten Falte (310) des flexiblen Substrats, das in dem ersten Biegebereich gefaltet ist, und der Hauptachse schräg ist,
wobei der mindestens eine Segmentverbinder ein zweites Kontaktelement zum Kontaktieren eines zweiten elektrischen Anschlusses des Batteriesegments aufweist, wobei das zweite Kontaktelement (204) über einen zweiten Kontaktleiter (208) mit dem Anschlussleiter verbunden ist, wobei der zweite Kontaktleiter (208) einen zweiten Biegebereich (212) umfasst,
wobei jedes der ersten und zweiten Kontaktelemente ein Paar von Kontaktanschlüssen umfasst; und
eine Überwachungseinheit (400), wobei der erste und der zweite Kontaktleiter des mindestens einen Segmentverbinders über die Überwachungseinheit mit dem Verbindungsleiter verbunden ist und die Einheit eine Auswerteeinheit aufweist.

2. Kontaktierungseinheit nach Anspruch 1, **dadurch gekennzeichnet, dass** die mindestens eine Überwachungseinheit eine Kommunikationseinheit aufweist.

3. Kontaktierungseinheit nach einem der Ansprüche 1 bis 2, **dadurch gekennzeichnet, dass** der Modulverbinder zur Kommunikation mit einer Managementeinheit des Batteriemoduls ausgebildet ist.

4. Kontaktierungseinheit nach einem der Ansprüche 1 bis 3, **dadurch gekennzeichnet, dass** der Segmentverbinder so ausgelegt ist, dass er einen Pol (506) des Batteriesegments elektrisch kontaktiert.

5. Kontaktierungseinheit nach einem der Ansprüche 1 bis 4, **dadurch gekennzeichnet, dass** sich eine zweite Falte (312) des flexiblen Substrats, die im zweiten Biegebereich gefaltet ist, entlang der Richtung der Hauptachse erstreckt.

6. Kontaktierungseinheit nach Anspruch 5, **dadurch gekennzeichnet, dass** der erste Kontaktleiter einen dritten Biegebereich (314) aufweisend ist und ein dritter Winkel (γ) zwischen einer dritten, im dritten Biegebereich gefalteten Falte (314) des flexiblen Substrats und der Hauptachse 90° beträgt.

7. Kontaktierungseinheit nach einem der Ansprüche 1 bis 6, **dadurch gekennzeichnet, dass** die Kontaktseite einen Anschlussarm aufweisend ist,
wobei der Anschlussarm einen Anschlussarm (602) zur Verbindung mit dem Batteriemodul aufweisend ist,
wobei der Anschlussarm über einen Anschlussarmleiter (606) mit einem der Anschlüsse des Modulanschlusses verbunden ist, wobei der Anschlussarmleiter einen vierten Biegebereich (616) aufweisend ist, und
wobei ein vierter Winkel (δ) zwischen einer vierten Falte (316) des flexiblen Substrats, die in dem vierten Biegebereich gefaltet ist, und der Hauptachse schräg ist.

8. Kontaktierungssystem, aufweisend mindestens zwei Kontaktierungseinheiten (100, 100a, 100b) nach einem der Ansprüche 1 bis 7, wobei jeweils der erste und der zweite Anschluss von benachbarten Verbindungseinheiten miteinander verbunden sind.

9. Batteriemodul (500) mit mindestens einem Batteriesegment (502), **dadurch gekennzeichnet, dass** das Batteriesegment von mindestens einer Kontaktierungseinheit (100) nach einem der Ansprüche 1 bis 8 kontaktiert wird.

10. Batteriemodul nach Anspruch 9, **dadurch gekennzeichnet, dass** das erste und das zweite Kontaktelement mit dem Batteriesegment verschweißt sind.

11. Batteriemodul nach einem der Ansprüche 9 oder 10, **dadurch gekennzeichnet, dass** das Batteriesegment mindestens eine Batteriezelle aufweist.

12. Verfahren zur Kontaktierung mindestens eines Batteriesegments eines Batteriemoduls, Bereitstellen eines Modulverbinders mit einem ersten Anschluss und einem zweiten Anschluss zur Verbindung mit dem Batteriemodul, wobei der erste Anschluss über einen Verbindungsleiter in Richtung einer Hauptachse der Kontaktierungseinheit mit dem zweiten Anschluss verbunden ist,
Bereitstellen mindestens eines Segmentverbinders mit einem ersten Kontaktelement zur Kontaktierung eines ersten elektrischen Anschlusses des Batteriesegments, wobei das erste Kontaktelement über einen ersten Kontaktleiter mit dem Anschlussleiter verbunden ist, wobei der erste Kontaktleiter einen ersten Biegebereich aufweist, wobei der Segmentverbinder ein zweites Kontaktelement zur Kontaktierung eines zweiten elektrischen Anschlusses des Batteriesegments aufweisend ist, wobei das zweite Kontaktelement (204) über einen zweiten Kontaktleiter (208) mit dem Anschlussleiter verbunden ist, der einen zweiten Biegebereich (212) aufweist und
wobei jedes der ersten und zweiten Kontaktelemente ein Paar von Kontaktanschlüssen aufweist, die eine Überwachungseinheit (400) bereitstellen, wobei der erste und der zweite Kontaktleiter des mindestens einen Segmentverbinders über die Überwachungseinheit mit dem Verbindungsleiter verbunden ist und die mindestens eine Überwachungseinheit eine Auswerteeinheit aufweist, die ein flexibles Substrat mit einer Kontaktseite bereitstellt, wobei die Kontaktseite den Modulverbinder und den mindestens einen Segmentverbinder aufweist,
Falten des flexiblen Substrats im ersten Biegebereich, wobei der Winkel zwischen einer ersten Falte und der Hauptachse schräg ist, und
Kontaktieren des Batteriesegments des Elektronikmoduls mit dem ersten Kontaktelement und dem zweiten Kontaktelement.

## Revendications

1. Unité de mise en contact (100) pour la mise en contact électrique d'au moins un segment de batterie (502) d'un module de batterie (500), comprenant :
un connecteur de module comportant une première borne (102) et une deuxième borne (104) pour une connexion au module de batterie, dans laquelle la première borne est connectée à la deuxième borne via un conducteur de connexion (106) en direction d'un axe principal (110) de l'unité de mise en contact,
au moins un connecteur de segment comportant un premier élément de contact (202) destiné à entrer en contact avec une première borne électrique du segment de batterie, dans laquelle le premier élément de contact est connecté au conducteur de connexion via un premier conducteur de contact (206), dans laquelle le premier conducteur de contact (206) comprend une première région de courbure (210),
un substrat flexible (300) ayant un côté de contact (302), dans laquelle le côté de contact comprend le connecteur de module et le connecteur de segment,
dans lequel un angle (α) entre un premier pli (310) du substrat flexible, plié dans la première région de courbure, et l'axe principal est oblique,
dans lequel ledit au moins un connecteur de segment comprend un deuxième élément de contact pour entrer en contact avec une deuxième borne électrique du segment de batterie, dans laquelle le deuxième élément de contact (204) est connecté au conducteur de connexion via un deuxième conducteur de contact (208), le deuxième conducteur de contact (208) comprenant une deuxième région de courbure (212),
dans lequel chacun des premier et deuxième éléments de contact comprend une paire de bornes de contact ; et
une unité de surveillance (400), dans laquelle le premier conducteur de contact et le deuxième conducteur de contact dudit au moins un connecteur de segment sont connectés au conducteur de connexion via l'unité de surveillance, et l'unité comprend une unité d'évaluation.

2. Unité de mise en contact selon la revendication 1, **caractérisée en ce que** ladite au moins une unité de surveillance comprend une unité de communication.

3. Unité de mise en contact selon l'une quelconque des revendications 1 et 2, **caractérisée en ce que** le connecteur de module est adapté pour communiquer avec une unité de gestion du module de batterie.

4. Unité de mise en contact selon l'une quelconque des revendications 1 à 3, **caractérisée en ce que** le connecteur de segment est adapté pour entrer en contact électrique avec un pôle (506) du segment de batterie.

5. Unité de mise en contact selon l'une quelconque des revendications 1 à 4, **caractérisée en ce qu'**un deuxième pli (312) du substrat flexible, plié dans la deuxième région de courbure, s'étend en direction de l'axe principal.

6. Unité de mise en contact selon la revendication 5, **caractérisée en ce que** le premier conducteur de contact comprend une troisième région de courbure (314) et **en ce qu'**un troisième angle (γ) entre un troisième pli (314) du substrat flexible, plié dans la troisième région de courbure, et l'axe principal est de 90°.

7. Unité de mise en contact selon l'une quelconque des revendications 1 à 6, **caractérisée en ce que** le côté de contact comprend un connecteur à bras,
dans laquelle le connecteur à bras comprend une borne de bras de liaison (602) pour une connexion au module de batterie,
dans laquelle la borne de bras de liaison est connectée à l'une des bornes du connecteur de module via un conducteur de bras de liaison (606), le conducteur de bras de liaison comprend une quatrième région de courbure (616), et
dans laquelle un quatrième angle (δ) entre un quatrième pli (316) du substrat flexible, plié dans la quatrième région de courbure, et l'axe principal est oblique.

8. Système de mise en contact, comprenant au moins deux unités de mise en contact (100, 100a, 100b) selon l'une quelconque des revendications 1 à 7, dans lequel, dans chaque cas, la première borne et la deuxième borne d'unités de mise en contact adjacentes sont connectées entre elles.

9. Module de batterie (500) comportant au moins un segment de batterie (502), **caractérisé en ce que** le segment de batterie est mis en contact par au moins une unité de mise en contact (100) selon l'une quelconque des revendications 1 à 8.

10. Module de batterie selon la revendication 9, **caractérisé en ce que** les premier et deuxième éléments de contact sont soudés au segment de batterie.

11. Module de batterie selon soit la revendication 9, soit la revendication 10, **caractérisé en ce que** le segment de batterie comprend au moins une cellule de batterie.

12. Procédé de mise en contact d'au moins un segment de batterie d'un module de batterie, comprenant
la fourniture d'un connecteur de module comportant une première borne et une deuxième borne pour une connexion au module de batterie, dans lequel la première borne est connectée à la deuxième borne via un conducteur de connexion dans la direction d'un axe principal de l'unité de mise en contact,
la fourniture d'au moins un connecteur de segment comportant un premier élément de contact pour mettre en contact une première borne électrique du segment de batterie, dans lequel le premier élément de contact est connecté au conducteur de connexion via un premier conducteur de contact, dans lequel le premier conducteur de contact comprend une première région de courbure, dans lequel le connecteur de segment comprend un deuxième élément de contact pour mettre en contact une deuxième borne électrique du segment de batterie, dans lequel le deuxième élément de contact (204) est connecté au conducteur de connexion via un deuxième conducteur de contact (208), qui comprend une deuxième région de courbure (212), et dans lequel chacun des premier et deuxième éléments de contact comprend une paire de bornes de contact,
la fourniture d'une unité de surveillance (400), dans lequel les premier et deuxième conducteurs de contact dudit au moins un connecteur de segment sont connectés au conducteur de connexion via l'unité de surveillance et ladite au moins une unité de surveillance comprend une unité d'évaluation fournissant un substrat flexible ayant un côté de contact, dans lequel le côté de contact comprend le connecteur de module et ledit au moins un connecteur de segment,
le pliage du substrat flexible dans la première région de courbure, dans lequel l'angle entre un premier pli et l'axe principal est oblique, et
la mise en contact du segment de batterie du module électronique avec le premier élément de contact et le deuxième élément de contact.
